# EUROPEAN PATENT APPLICATION

(11) **EP 4 776 789 A1**
(43) Date of publication of application: **15.07.2026**
(21) Application number: 25212389.8
(22) Date of filing: 30.10.2025
(51) Int. Cl.: H10D 62/10, H10D 30/01, H10D 30/67, H10D 84/01, H10D 84/03, H10D 88/00, H10P 14/60

(54) **VERTICAL TRANSISTOR INCLUDING GATE INSULATING LAYER AND MANUFACTURING METHOD THEREOF**

(30) Priority: 08.01.2025 KR 20250002764
(71) Applicant: UNIST (Ulsan National Institute of Science and Technology), Ulsan 44919 (KR)
(72) Inventor: KWON, Jimin, Ulsan (KR); LEE, Yongwoo, Ulsan (KR); PARK, Minho, Ulsan (KR); LEE, Hyeonjin, Ulsan (KR); JUNG, Haksoon, Ulsan (KR)
(74) Representative: Dantz, Jan Henning

(57) **Abstract**

According to various embodiments, a method for manufacturing a semiconductor device having a vertical structure may be provided, the method comprising: forming a first insulator on a substrate, a first conductor on the first insulator, a second insulator disposed on the first conductor, a gate on the second insulator, a third insulator on the gate, and a second conductor on the third insulator; forming a hole penetrating the second conductor, the third insulator, the gate, the second insulator, and the first conductor; and forming an insulating layer on an inner surface of the gate based on growing a blocking material on a remaining inner surface excluding the inner surface of the gate formed by the hole.

## Description

### FIELD

The present disclosure relates to a vertical transistor including a gate insulating layer and a manufacturing method thereof, and is intended to provide a vertical transistor that includes a gate insulating layer formed based on selectively depositing a blocking smaterial.

### BACKGROUND

In order to overcome the Short-Channel Effect by developing a 3D structure semiconductor device, various 3D structure devices such as FinFET, Gate-All-Around (GAA), and Channel-All-Around (CAA) are currently being researched.

Among these, the demand for technology regarding three-dimensional field-effect transistors with a vertical structure is increasing, as they offer advantages in terms of integration density and channel controllability.

In the case of conventional three-dimensional field-effect transistors with a vertical structure, an insulating film is formed between the source, the drain, and the channel according to general processes, leading to a significant burden for electrical connection between the source, the drain, and the channel due to process limitations. Furthermore, research has been conducted on the use of wet etching to form a trench structure in the gate to form an insulating film only between the gate and the channel, but limitations in process control make it difficult to implement transistors on the nanometer (nm) scale.

Therefore, to resolve the conventional process limitations, a vertical structure semiconductor device including a gate insulating layer and a manufacturing method thereof according to various embodiments may provide a manufacturing method in which an insulating layer is formed only between the gate and the channel of the vertical structure transistor, based on an AS-ALD process utilizing self-assembled monolayers (SAM).

In addition, a vertical structure semiconductor device including a gate insulating layer and a manufacturing method thereof according to various embodiments can provide a memory semiconductor structure that includes various types of transistors, such as CAA and GAA transistors, which are capable of controlling the overall characteristics (e.g., conductivity) of the channel in the implemented vertical structure transistor.

The problems to be solved by the present application are not limited to the above-mentioned problems, and unmentioned problems will be clearly understood by one of ordinary skill in the art to which the present application belongs from this specification and the accompanying drawings.

### BRIEF SUMMARY

According to various embodiments, a method for manufacturing a semiconductor device having a vertical structure may be provided, comprising the steps of:forming a first insulator on a substrate, a first conductor on the first insulator, a second insulator disposed on the first conductor, a gate on the second insulator, a third insulator on the gate, and a second conductor on the third insulator;
forming a hole penetrating the second conductor, the third insulator, the gate, the second insulator, and the first conductor;
forming an insulating layer on an inner surface of the gate based on growing SAM on a remaining inner surface excluding the inner surface of the gate formed by the hole; and
forming a channel layer along the same plane formed by the inner surface of the second conductor, the inner surface of the third insulator, the inner surface of the insulating layer, the inner surface of the second insulator, and the inner surface of the first conductor.

According to various embodiments, a semiconductor device may be provided, comprising: a first conductor; a first insulator disposed on the first conductor; a gate disposed on the first insulator; a second insulator disposed on the gate; a second conductor disposed on the second insulator; a channel layer formed along an inner surface formed by a hole vertically penetrating the second conductor, the second insulator, the gate, and the first insulator; and an insulating layer disposed between the channel layer and the gate, wherein one of the first conductor and the second conductor is a source and the other is a drain, and the inner surface of the second conductor, the inner surface of the second insulator, the inner surface of the insulating layer, and the inner surface of the first insulator, which are formed by the hole, form the same plane, and the channel layer is formed along the same plane.

The means for solving the problem are not limited to the solutions described above, and unmentioned solutions will be clearly understood by one of ordinary skill in the art to which the present application belongs from this specification and the accompanying drawings.

According to various embodiments, a manufacturing method can be provided in which an insulating layer is formed only between the gate and the channel of the vertical structure transistor, based on an AS-ALD process utilizing self-assembled monolayers (SAM).

Furthermore, according to various embodiments, a memory semiconductor structure can be provided, which includes a transistor capable of controlling the overall characteristics (e.g., conductivity) of the channel in the implemented vertical structure transistor.

### DESCRIPTION OF THE FIGURES

FIG. 1 is a schematic perspective view illustrating the structure of a GAA semiconductor device.
FIG. 2 is a perspective view illustrating the inside of the GAA semiconductor device shown in FIG. 1.
FIG. 3 is a cross-sectional view of the GAA semiconductor device shown in FIGS. 1 to 2, cut along the x-z plane based on the axis c, and a view illustrating a comparative example.
FIG. 4 is a view illustrating an example of a method for manufacturing a GAA semiconductor device according to various embodiments.
FIG. 5 is a view illustrating an example of a method for forming an insulating layer only between the gate and the channel layer by selectively removing SAM according to various embodiments.
FIG. 6 is a view illustrating an example of a method for forming an insulating layer only between the gate and the channel layer by selectively attaching SAM according to various embodiments.
FIG. 7 is a view illustrating an example of SAM according to various embodiments.
FIG. 8 is a view illustrating a structure in which a plurality of vertical GAA semiconductor devices are connected according to various embodiments.
FIGS. 9A to 9B are views illustrating a method for manufacturing the connected structure of the plurality of vertical GAA semiconductor devices according to various embodiments.
FIG. 10A is a view illustrating an example of a structure in which a GAA semiconductor device and a CAA semiconductor device are combined according to various embodiments.
FIG. 10B is a view illustrating an example of the operation of the structure according to various embodiments.
FIG. 11 is a view illustrating an example of a structure in which a GAA semiconductor device and a CAA semiconductor device are combined according to various embodiments.
FIG. 12 is a view illustrating an example of the operation of the structure according to various embodiments.
FIG. 13 is a view illustrating an example of a structure in which an oxygen tunnel is formed according to various embodiments.

### DESCRIPTION OF EMBODIMENTS

Specific structural or functional descriptions for various embodiments are exemplified only for the purpose of describing the various embodiments, and the various embodiments may be implemented in various forms and should not be construed as being limited to the embodiments described in this specification or application.

Since various embodiments are capable of various modifications and various forms, various embodiments are illustrated in the drawings and are intended to be described in detail in this specification or application.

However, what is disclosed from the drawings is not intended to particularize or limit the various embodiments, and it should be understood to include all changes, equivalents, and substitutes included in the spirit and technical scope of the various embodiments.

Terms such as a first and/or a second may be used to describe various components, but the components should not be limited by these terms.

These terms are used only for the purpose of distinguishing one component from another, and for example, without departing from the scope of the rights according to the concept of the present disclosure, a first component may be named as a second component, and similarly, a second component may also be named as a first component.

When a component is referred to as being "connected" or "coupled" to another component, it is to be understood that it may be directly connected or coupled to the other component, or that an intervening component may be present.

In contrast, when a component is referred to as being "directly connected" or "directly coupled" to another component, it is to be understood that no intervening component is present.

Other expressions describing the relationship between components, that is, "between" and "immediately between" or "adjacent to" and "directly adjacent to," shall be interpreted in the same manner.

The terminology used herein is for the purpose of describing particular embodiments only and is not intended to limit the various embodiments.

The singular expressions include plural expressions, unless the context clearly indicates otherwise.

As used herein, the terms "comprise" or "have" are intended to specify the presence of stated features, numbers, steps, operations, components, parts, or combinations thereof, and do not preclude the presence or addition of one or more other features, numbers, steps, operations, components, parts, or combinations thereof.

Unless otherwise defined, all terms used herein, including technical or scientific terms, have the same meaning as commonly understood by one of ordinary skill in the art to which this disclosure belongs.

Terms such as those defined in generally used dictionaries should be interpreted as having meanings consistent with their meanings in the context of the relevant art and should not be interpreted in an idealized or overly formal sense, unless expressly defined in this specification.

Hereinafter, the present disclosure will be described in detail by explaining preferred embodiments of the present disclosure with reference to the accompanying drawings.

The same reference numerals are used to designate the same elements in the drawings.

According to various embodiments, a semiconductor device may be provided, comprising: a first conductor; a first insulator disposed on the first conductor; a gate disposed on the first insulator; a second insulator disposed on the gate; a second conductor disposed on the second insulator; a channel layer formed along an inner surface formed by a hole vertically penetrating the second conductor, the second insulator, the gate, and the first insulator; and an insulating layer disposed between the channel layer and the gate, wherein one of the first conductor and the second conductor is a source and the other is a drain, and the inner surface of the second conductor, the inner surface of the second insulator, the inner surface of the insulating layer, and the inner surface of the first insulator, which are formed by the hole, form the same plane, and the channel layer is formed along the same plane.

According to various embodiments, a semiconductor device may be provided, wherein the insulating layer is formed between the inner surface of the gate and the channel layer.

According to various embodiments, a semiconductor device may be provided, wherein the insulating layer is formed on the inner surface of the gate by depositing the material of the insulating layer in a state where SAM is grown on the remaining portion excluding the gate.

According to various embodiments, a semiconductor device may be provided, wherein the functional group of the SAM is configured to prevent the deposition of the material of the insulating layer.

According to various embodiments, a semiconductor device may be provided, wherein an additional insulating layer and an additional gate are formed in the hole, and the conductivity of the channel layer is adjustable by the additional gate.

According to various embodiments, a method for manufacturing a semiconductor device having a vertical structure may be provided, comprising the steps of: forming a first insulator on a substrate, a first conductor on the first insulator, a second insulator disposed on the first conductor, a gate on the second insulator, a third insulator on the gate, and a second conductor on the third insulator; forming a hole penetrating the second conductor, the third insulator, the gate, the second insulator, and the first conductor; forming an insulating layer on an inner surface of the gate based on growing SAM on a remaining inner surface excluding the inner surface of the gate formed by the hole; and forming a channel layer along the same plane formed by the inner surface of the second conductor, the inner surface of the third insulator, the inner surface of the insulating layer, the inner surface of the second insulator, and the inner surface of the first conductor.

According to various embodiments, a manufacturing method may be provided, wherein the functional group of the SAM is configured to prevent the deposition of the material of the insulating layer.

According to various embodiments, a manufacturing method may be provided, wherein the step of forming an insulating layer on the inner surface of the gate comprises: growing the SAM on the inner surface formed by the hole; selectively etching only the gate for a pre-set time; and depositing the insulating layer in a trench structure formed in the gate in a state where SAM is grown on the remaining portion excluding the gate.

According to various embodiments, a manufacturing method may be provided, wherein the etching time is ~.

According to various embodiments, a manufacturing method may be provided, wherein the step of forming an insulating layer on the inner surface of the gate comprises: hydrophilizing the inner surface formed by the hole; selectively etching only the gate for a pre-set time; growing the SAM only on the remaining portion in a state where the remaining portion excluding the gate is hydrophilized; and depositing the insulating layer in a trench structure formed in the gate in a state where SAM is grown on the remaining portion excluding the gate.

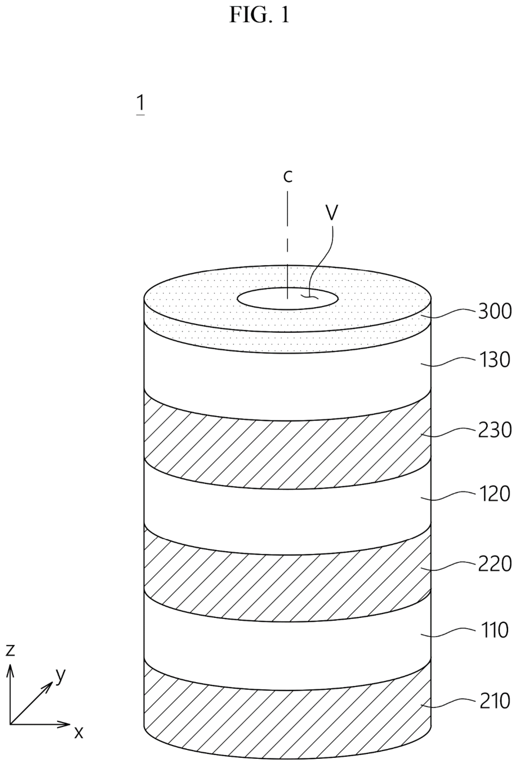

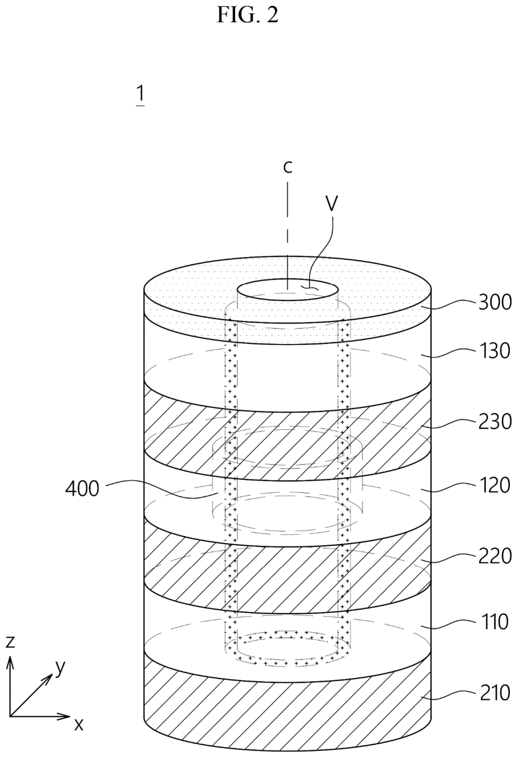

FIG. 1 is a schematic perspective view illustrating the structure of a GAA semiconductor device 1. Hereinafter, the GAA semiconductor device 1 of FIG. 1 will be further described with reference to FIGS. 2 to 3.

FIG. 2 is a perspective view illustrating the inside of the GAA semiconductor device 1 shown in FIG. 1.

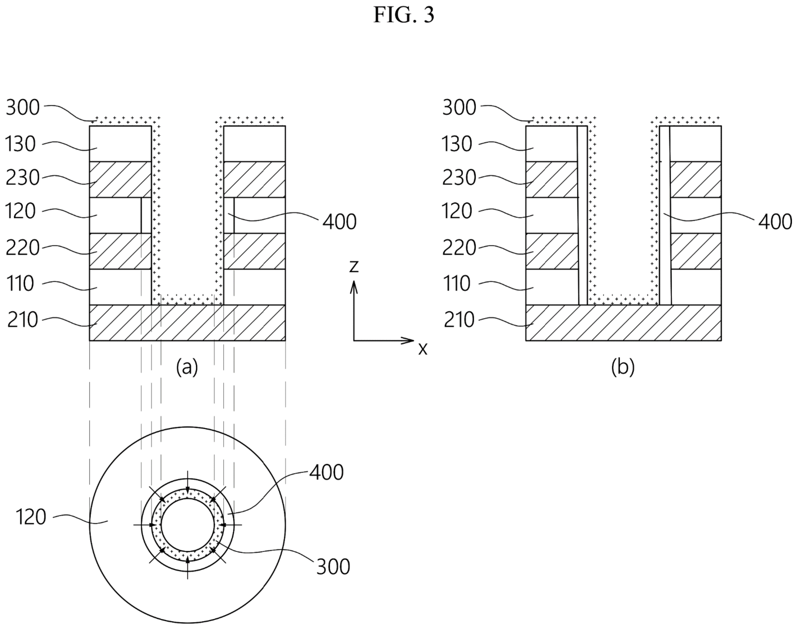

FIG. 3 is a cross-sectional view of the GAA semiconductor device 1 shown in FIGS. 1 to 2, cut along the x-z plane based on the axis c, and a view illustrating a comparative example.

According to various embodiments, referring to FIGS. 1 and 2, the GAA semiconductor device 1 may include a first insulator 210, a source 110 disposed on the first insulator 210, a second insulator 220 disposed on the source 110, a gate 120 disposed on the second insulator 220, a third insulator 230 disposed on the gate 120, a drain 130 disposed on the third insulator 230, a channel layer 300, and an insulating layer 400 formed between the gate 120 and the channel layer 300.

Referring to FIGS. 1 and 2, the GAA semiconductor device 1 may include a hole V (or groove) penetrating some of the insulators (210, 220, 230) (e.g., 220, 230), the source 110, the gate 120, and the drain 130.

However, another transistor may be further formed in the hole V, and for example, a Channel All Around (CAA) structure transistor may be implemented.

Meanwhile, without being limited to the examples described and/or illustrated, the source 110 may be implemented as the drain 210, and the drain 210 may be implemented as the source 110.

According to various embodiments, the source 110, the gate 120, and the drain 130 may be a conductor.

The source 110, the gate 120, and the drain 130 may be composed of TiN, TaN, WN, TiSiN, WSiN, ITO, IZO, ZTO, Poly-Si, Au, Al, Ag, Be, Bi, Co, Cu, Cr, Hf, In, Mn, Mo, Mg, Ni, Nb, Pb, Pd, Pt, Rh, Re, Ru, Sb, Ta, Te, Ti, V, W, Zr, Zn, Mxene, or PEDOT:PSS, or a combination thereof.

A void space due to the hole 300 may be formed in the center region of the source 110, the gate 120, and the drain 130.

According to various embodiments, the insulators (210, 220, 230) and the insulating layer 400 may include, for example, SiNx, SiO2, SiCN, SiBN, SiON, SiOCN, SiBCN, SiOC, or a combination thereof.

Each of the insulators (210, 220, 230) may be disposed between the source 110, the gate 120, and the drain 130, so as to be electrically insulated from each other.

In addition, the insulating layer 400 may be disposed between the channel layer 300 and the gate 120, so as to be electrically insulated from each other.

According to various embodiments, the channel layer 300 may be implemented with a material that allows electron movement.

For example, the channel layer 300 may be composed of IGZO (InGaZnO), Sn-IGZO, IWO (InWO), IZO (InZnO), ZTO (ZnSnO), ZnO, YZO (yttrium-doped zinc oxide), IGSO (InGaSiO), InO, SnO, TiO, ZnON, MgZnO, ZrInZnO, HfInZnO, SnInZnO, SiInZnO, GaZnSnO, ZrZnSnO, CNT, Graphene, Transition Metal Dichalcogenide (MoSe2, WSe2 MoS2, WS2), InSe, Silicon, SiC, GaN, AIN, Ge, SiGe, GaAs, InGaAs, Poly(3,4-ethylenedioxythiophene):poly(styrenesulfonate) (PEDOT : PSS), polypyrrole, polythiophene, polyphenylene, polyphenylene vinylene, poly(3,4-ethylenedioxythiophene):tosylate (PEDOT:TOS), poly(6-(thiophen-3-yl)hexane-1-sulfonate) tetrabutylammonium (PTHS), poly(4-(2,3-dihydrothieno[3,4-b][1,4]dioxin-2-yl-methoxy)-1-butanesulfonic acid) (PEDOT-S), poly(2-(3,3'bis(2-(2-(2-methoxyethoxy)ethoxy)ethoxy)-[2,2'bithiophene]-5-yl)thieno[3,2-B]thiophene) (p(g2T-TT)), and poly((ethoxy)ethyl 2-(2-(2-methoxyethoxy)ethoxy)acetate)-naphthalene-1,4,5,8-tetracarboxyl-diimide-co-3,3'bis(2-(2-(2-methoxyethoxy)ethoxy)ethoxy)-(bithiophene)) (p(gNDI-g2T)), or a combination thereof.

Preferably, the semiconductor layer 330 may be implemented as IGZO (InGaZnO), which has a low leakage current and excellent electron mobility.

According to various embodiments, the channel layer 300 may be formed on the drain 130, formed on the side surfaces of the void space of the drain 130, the third insulator 230, the insulating layer 400, the second insulator 220, and the source 110, and formed on the top of the first insulator 210.

That is, the inner surface of the void space of the GAA semiconductor device 1 formed by the hole V may be covered by the channel 300.

Accordingly, the channel layer 300 can be formed in the vertical direction (e.g., the z-axis), which can be defined as the semiconductor device having a vertical structure.

In addition, the channel layer 300 may be surrounded by the source 110, the gate 120, and the drain 130.

The source 110 and the drain 210 can be electrically connected by the channel layer 300.

The current flow of the channel layer 300 can be controlled by the voltage (VG) applied to the gate 120 surrounding the channel layer 300.

FIG. 3 (b) shows a cross-section of the gate 120 of the semiconductor device 1 cut along the x-y plane.

Referring to FIG. 3 (b), based on the outer surface of the channel layer 300 being surrounded by the gate 120, the influence on the channel layer 300 by the voltage (VG) applied to the gate 120 can be increased.

This can be defined as high controllability over the channel layer 300.

At this time, the insulating layer 400 electrically insulates the channel layer 300 and the gate 120 from each other, thereby improving electrical stability.

FIG. 3 (a) shows the GAA semiconductor device 1 in which the AS-ALD based insulating layer 400 proposed by the present invention is formed, and FIG. 3 (b) shows a semiconductor device in which the insulating layer 400 is formed by a general process.

In the case of FIG. 3 (b), according to a general process, the source 110 and the drain 210 cannot be electrically connected to the channel layer 300 by the insulating layer 400, making it difficult to operate as a transistor device.

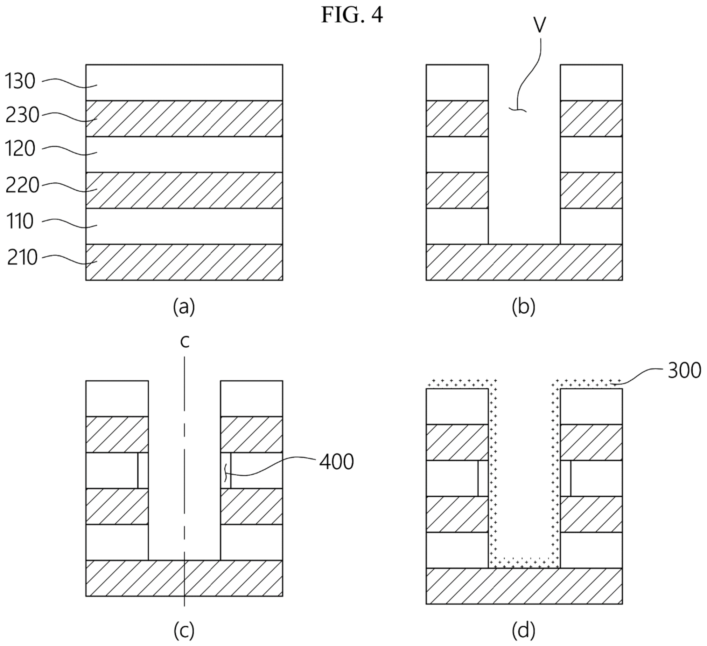

Therefore, the method of forming the insulating layer 400 only between the gate 120 and the channel layer 300, which will be described with reference to FIGS. 4 to 7 below and is a manufacturing method of the present invention, may be necessary.

The channel layer 300 may be formed flatly without any protruding and/or recessed portions in the inner space formed by the hole V.

For example, the inner surfaces of the third insulator 230, the drain 130, the second insulator 220, the insulating layer 400, and the source 110 may form the same plane.

In other words, the distance from the central axis c to the inner surfaces of the third insulator 230, the drain 130, the second insulator 220, the insulating layer 400, and the source 110 may correspond to each other.

As the channel layer 300 is formed on the formed single plane, a shortest distance channel can be formed, thereby improving the performance of the semiconductor device 1.

However, without being limited to the described example, only the inner surface of the insulating layer 400 may be formed at a greater distance from the central axis c compared to the other parts, so that the region of the channel layer 300 disposed on the inner surface of the insulating layer 400 may be implemented to be recessed.

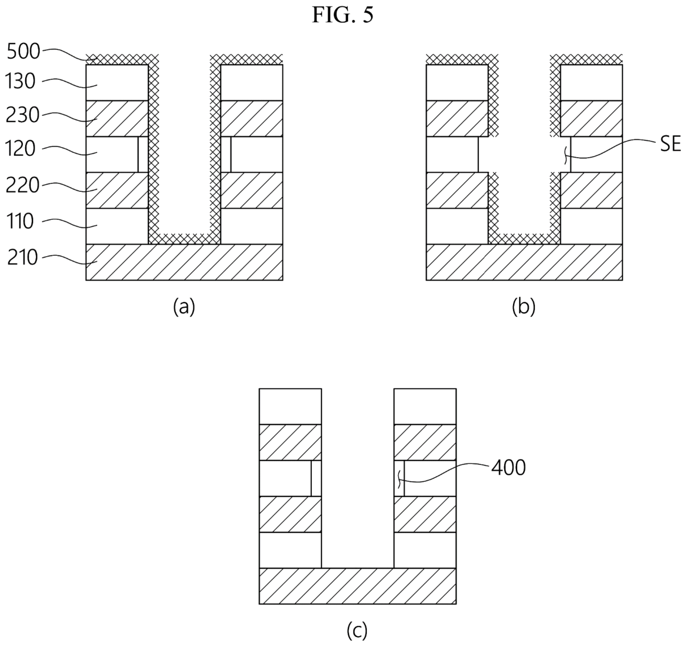

FIG. 4 is a view illustrating an example of a method for manufacturing a semiconductor device 1 according to various embodiments. Hereinafter, the method in FIG. 4 will be further described with reference to FIGS. 5 to 7.

FIG. 5 is a view illustrating an example of a method for forming the insulating layer 400 only between the gate 120 and the channel layer 300 by selectively removing SAM according to various embodiments.

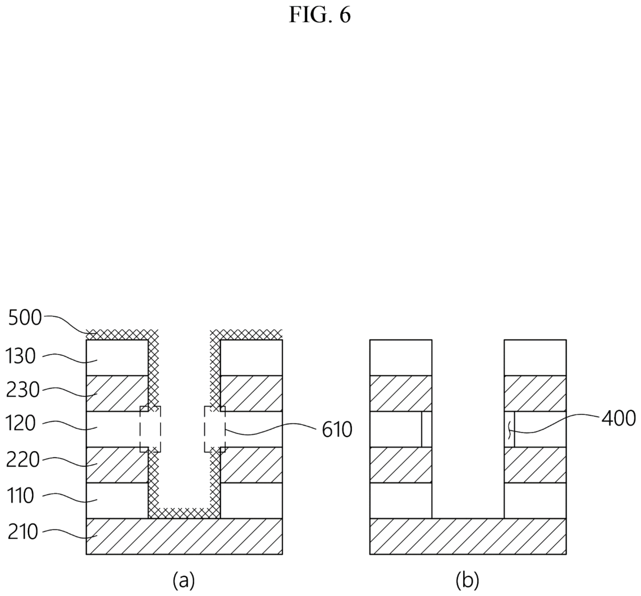

FIG. 6 is a view illustrating an example of a method for forming the insulating layer 400 only between the gate 120 and the channel layer 300 by selectively attaching SAM according to various embodiments.

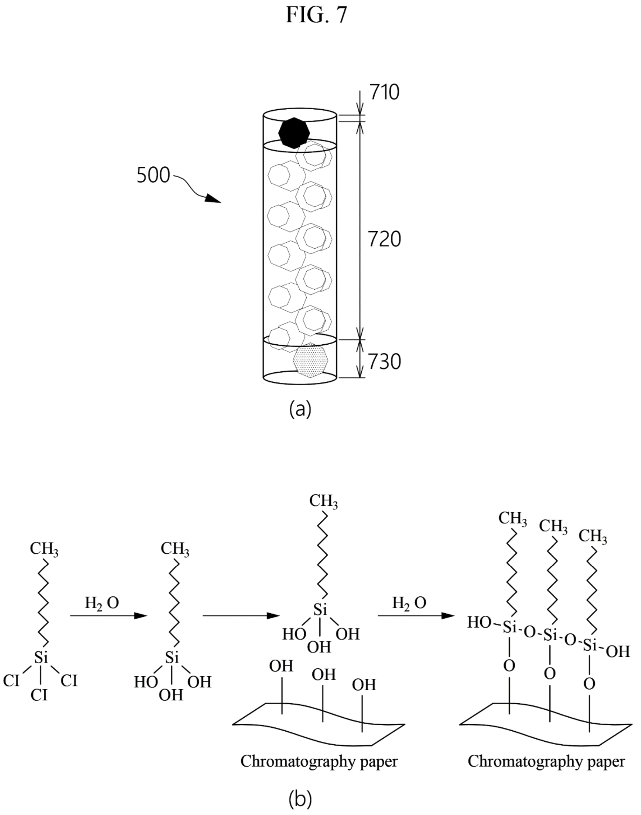

FIG. 7 is a view illustrating an example of SAM according to various embodiments.

Referring to FIG. 4 (a), the manufacturing method may include the step of forming a first insulator 210 on a substrate (not shown), a source 110 on the first insulator 210, a second insulator 220 disposed on the source 110, a gate 120 on the second insulator 220, a third insulator 230 on the gate 120, and a drain 130 on the third insulator 230.

Referring to FIG. 4 (b), the manufacturing method may include the step of forming a hole V penetrating the drain 130, the third insulator 230, the gate 120, the second insulator 220, and the source 110.

A part of the upper surface of the first insulator 210 may be exposed to the outside by the hole V.

Referring to FIG. 4 (c), the manufacturing method may include the step of forming an insulating layer 400 with a pre-set thickness, extending from the inner surface of the gate 120 toward the gate 120 from the central axis c inside the hole V.

Referring to FIGS. 5 and 6, for the formation of the insulating layer 400, based on forming a blocking material on the inner surface of the hole V other than the inner surface corresponding to the gate 120 (e.g., the inner surfaces of the source 130, the insulators 220, 230, and the drain 110, and the region of the first insulator 210 exposed by the groove V), the inner surface of the gate 120 can be etched by a pre-set thickness, and the insulating layer 400 can be formed in the etched part.

For example, the blocking material may be a material (or substance) to prevent (or suppress) the formation of the insulating layer 400, and may include self-assembled monolayers (SAM(500)) and a precursor, which will be described later.

Specific examples of the blocking material will be described below.

In one embodiment, an AS-ALD process may be performed, which involves growing self-assembled monolayers (SAM(500)) on the inner surface formed by the hole V, etching the inner surface of the gate 120 by a pre-set thickness, and forming the insulating layer 400 in the etched part of the gate 120.

According to various embodiments, the SAM(500) may be configured to prevent the attachment of the material for forming the insulating layer 400.

For example, the SAM(500) may have a hydrophilic end and a hydrophobic end facing outward.

The formation of the material of the insulating layer 400 can be prevented by the hydrophobic end.

For example, FIG. 7 (a) illustrates an example of the SAM(500).

Referring to FIG. 7 (a), the SAM(500) may include a functional group 710, a spacer 720, and a reactant 730.

The reactant 710 may have hydrophobicity to prevent the formation of the material of the insulating layer 400.

The spacer 720 may be a long chain molecule.

It can be polar, nonpolar, positively charged, negatively charged, or uncharged.

For example, saturated, unsaturated, straight-chain, or branched hydrocarbon or halogenated hydrocarbon-containing groups can be used.

The term hydrocarbon as used herein can refer to straight-chained, branched, and cyclic aliphatic and aromatic groups, and typically includes alkyl, alkenyl, alkynyl, cycloalkyl, cycloalkylalkyl, aryl, arylalkyl, arylalkenyl, and arylalkynyl.

The term "hydrocarbon-containing group" also allows for the presence of atoms other than carbon and hydrogen, typically, for example, oxygen and/or nitrogen.

For example, one or more methylene oxide or ethylene oxide moieties may be present within the hydrocarbon-containing group; alkylated amino groups may also be useful.

Suitably, the hydrocarbon group may include up to 35 carbon atoms, typically up to 30 carbon atoms, and more typically up to 20 carbon atoms.

Corresponding halogenated hydrocarbons, especially fluorinated hydrocarbons, can also be used.

In preferred cases, the fluorinated hydrocarbon can be represented by the general formula F(CF2)k(CH2)l, where k is typically an integer having a value between 1 and 30, and 1 is an integer having a value between 0 and 6.

More preferably, k is an integer between 5 and 20, especially between 8 and 18.

Of course, it is recognized that while the foregoing has been provided as preferred ranges for the values of k and l, the specific choices for k and l can vary in accordance with the principles of the present invention.

It will also be recognized that the term "hydrocarbon-containing group" also allows for the presence of atoms other than carbon and hydrogen, typically O or N, as described above.

The above hydrocarbon spacer group may also be further substituted with well-known substitutes in the art, such as C1-6 alkyl, phenyl, C1-6 haloalkyl, hydroxy, C1-6 alkoxy, C1-6 alkoxyalkyl, C1-6 alkoxyC1-6 alkoxy, aryloxy, keto, C2-6 alkoxycarbonyl, C2-6 alkoxycarbonyl1-6 alkyl, C2-6 alkylcarbonyloxy, arylcarbonyloxy, arylcarbonyl, amino, mono-or di- (C1-6)alkylamino, or any other suitable substitute known in the art.

The reactant 730 may have hydrophilicity.

Referring to FIG. 7 (b), the functional group 710 is configured to include a hydroxyl group (OH-) through hydrolysis, and can be bonded by dehydration reaction with the hydroxyl group (OH-) on the hydrophilic surface.

According to various embodiments, FIG. 5 illustrates a manufacturing method that forms the insulating layer 400 based on removing the SAM(500) corresponding to the side of the gate 120 after the SAM(500) is disposed as the aforementioned blocking material.

For example, referring to FIG. 5 (a), the manufacturing method may grow the SAM(500) in a state where the hole V is formed as in FIG. 4 (b).

The SAM(500) can be formed in the entire area of the inner surface formed by the hole V.

At this time, a layer that enables the growth of the blocking material may be formed in the entire area of the inner surface.

For example, a process of providing O2 plasma to the entire area for hydrophilization to form the SAM(500) may be performed.

In one example, the growth of the SAM(500) may be performed by immersing the structure with the hole V formed as in FIG. 4 (b) in a solution containing the SAM(500).

For another example, referring to FIG. 5 (b), the manufacturing method may include selectively etching only the inner surface of the gate 120 by providing an etchant to etch only the material of the gate 120 (e.g., wet etch), thereby forming a groove (SE) (or trench structure) of a pre-set thickness from the inner surface along with the removal of the SAM(500) grown on the inner surface of the gate 120.

For yet another example, referring to FIG. 5(c), the manufacturing method may include the step of forming the insulating layer 400 in a state where the SAM(500) is grown on the remaining region other than the inner surface of the gate 120 (e.g., the inner surfaces of the source 130, the insulators 220, 230, and the drain 110, and the region of the first insulator 210 exposed by the groove V) and the groove (SE) is formed in the gate 120.

The formation of the material of the insulating layer 400 is prevented in the remaining region (e.g., the inner surfaces of the source 130, the insulators 220, 230, and the drain 110, and the region of the first insulator 210 exposed by the groove V) by the functional group 710 of the formed SAM(500), and the insulating layer 400 can be formed only in the groove (SE).

Meanwhile, since the depth of the groove is determined in proportion to the etching time, the thickness of the insulating layer 400 varies according to the etching time, and if the thickness of the insulating layer 400 is implemented to be above the upper limit, a problem occurs where the insulating layer 400 is deposited in other regions, and if the thickness of the insulating layer 400 is implemented to be below the lower limit, a leakage current problem may occur, and therefore, the etching time must be optimally designed.

For example, the etching time may be from a few seconds to several tens of minutes.

Preferably, the etching time may be 2 to 10 minutes, and more preferably 4 to 6 minutes.

If the etching time is 6 minutes or longer, etching may be performed on regions other than the gate 120, thereby deteriorating the selectivity of etching, and if the etching time is less than 4 minutes, the gate 120 may not be etched enough for the insulating layer 400 to grow sufficiently, which may cause a leakage current.

According to various embodiments, FIG. 6 illustrates a manufacturing method that forms the insulating layer 400 based on selectively forming SAM(500) as an example of a blocking material only in the remaining region excluding the side of the gate 120 (e.g., the inner surfaces of the source 130, the insulators 220, 230, and the drain 110, and the region of the first insulator 210 exposed by the groove V).

For example, referring to FIG. 6 (a), the manufacturing method may grow the SAM(500) in the remaining region excluding the region 610 corresponding to the inner surface of the gate 120, in a state where the hole V is formed as in FIG. 4 (b).

In one example, the inner space formed by the hole V may be hydrophilized in the state where the hole V is formed, and after partially etching only the inner surface of the gate 120, the SAM(500) may be grown so that the SAM(500) is grown only in the remaining region excluding the inner surface of the gate 120.

In another example, UDA (CH3(CH2)9CHO) and BA (C6H5CHO), which only bind to the NH- functional group, can be utilized as the SAM(500).

For another example, referring to FIG. 6 (b), the manufacturing method may include the step of forming the insulating layer 400 in a state where the SAM(500) is grown on the remaining region and the groove (SE) is formed in the gate 120.

Meanwhile, precursors that selectively bind to the remaining region excluding the region corresponding to the gate 120 (e.g., the inner surfaces of the source 130, the insulators 220, 230, and the drain 110, and the region of the first insulator 210 exposed by the groove V) can be used instead of the SAM(500).

For example, precursors that are chemically adsorbed to the hydroxyl group (-OH) having hydrophilicity and have a functional group that prevents the formation of the material of the insulator 400 can be used.

In one example, the precursor may include Aminosilane and BDIPADS.

For another example, the precursor may include FeOx.

Referring to FIG. 4 (d), the manufacturing method may include the step of forming the channel layer 300 in a state where the insulating layer 400 is formed.

As described above, for example, the inner surfaces of the third insulator 230, the drain 130, the second insulator 220, the insulating layer 400, and the source 110 may form the same plane.

Accordingly, the channel layer 300 can be formed flatly without any protruding and/or recessed portions in the inner space formed by the hole V.

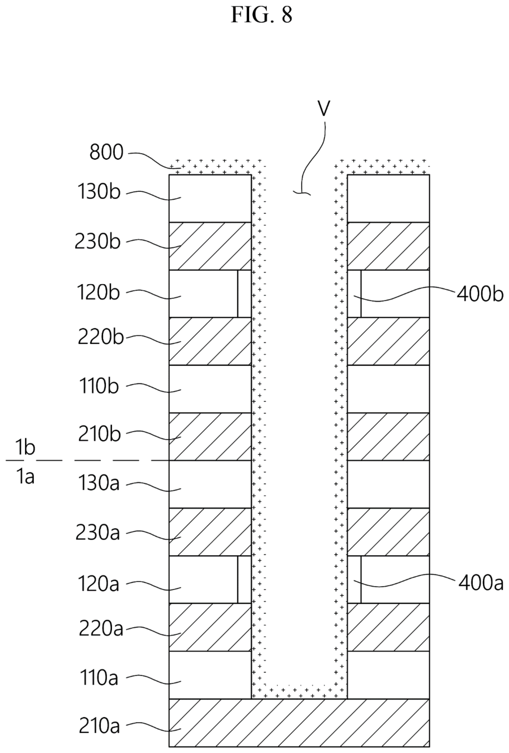

FIG. 8 is a view illustrating a structure in which a plurality of vertical GAA semiconductor devices (1a, 1b) are connected according to various embodiments.

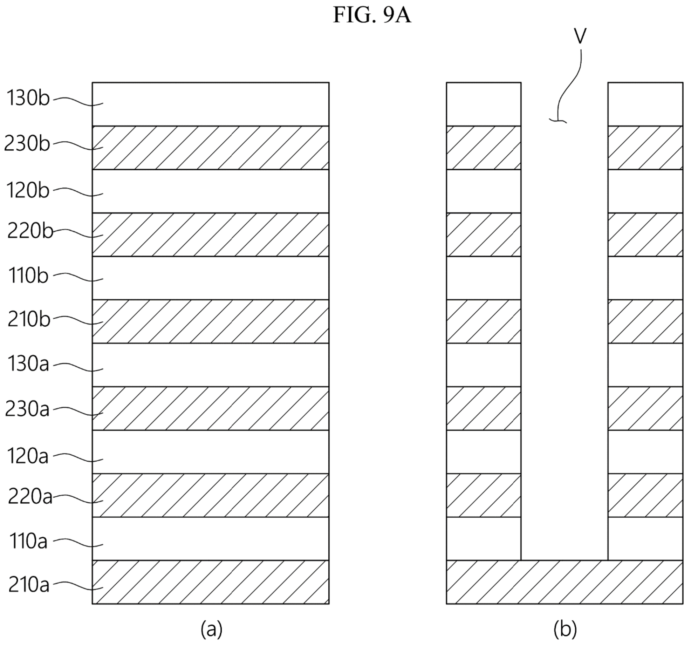

FIGS. 9a to 9b are views illustrating a method for manufacturing the connected structure of the plurality of vertical GAA semiconductor devices (1a, 1b) according to various embodiments.

According to various embodiments, referring to FIG. 8, a structure including a plurality of GAA semiconductor devices (1a, 1b), each including the aforementioned insulators (210a, 210b, 220a, 220b, 230a, 230b), sources (110a, 110b), gates (120a, 120b), drains (130a, 130b), a channel layer 800, and insulating layers (400a, 400b), may be manufactured.

The components included in the structure are the same as the example of the aforementioned GAA semiconductor device 1, so redundant descriptions will be omitted.

The hole V is formed to penetrate all the parts other than the lowest insulator (210a) among the insulators (210a, 210b, 220a, 220b, 230a, 230b), the sources (110a, 110b), the gates (120a, 120b), the drains (130a, 130b), the channel layer 800, and the insulating layers (400a, 400b), and the channel layer 800 can be formed along the inner surface thus formed.

The structure can function as a NAND or AND circuit.

For example, a charge trap layer may be selectively grown based on AS-ALD on at least a part of the channel layer 800 so that the structure functions as a NAND or AND circuit.

Referring to FIG. 9A (a), the manufacturing method may include the step of repeating the process of FIG. 4 (a) for the number of semiconductor devices to be formed.

Accordingly, the insulators (210a, 210b, 220a, 220b, 230a, 230b), the sources (110a, 110b), the gates (120a, 120b), and the drains (130a, 130b) can be formed.

Referring to FIG. 9A (b), the manufacturing method may include the step of forming a hole V penetrating the insulators (210b, 220a, 220b, 230a, 230b), the sources (110a, 110b), the gates (120a, 120b), and the drains (130a, 130b).

A part of the upper surface of the first-first insulator (210a) may be exposed to the outside by the hole V.

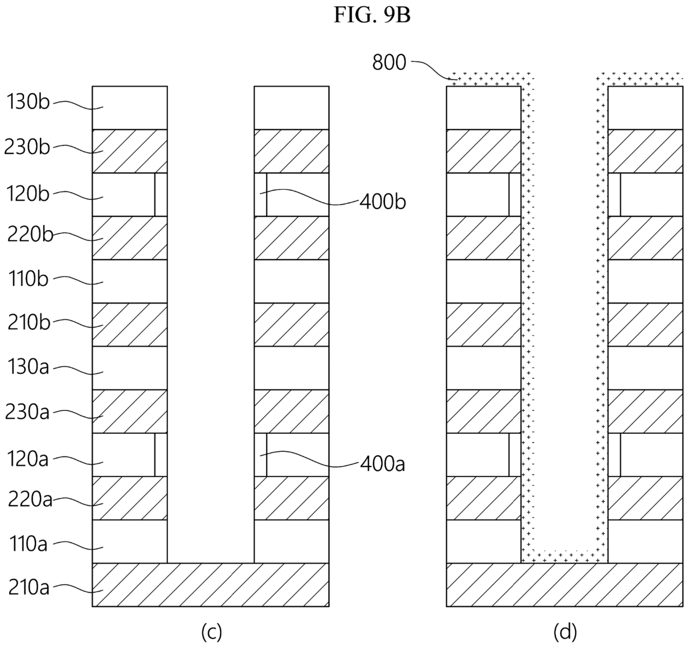

Referring to FIG. 9B (c), the manufacturing method may include the step of forming an insulating layer 400 with a pre-set thickness, extending from the inner surface of the gate 120 toward the gates (120a, 120b) from the central axis c inside the hole V.

The step of forming the insulating layer 400 can be performed by the formation of SAM 500 as described above, so redundant descriptions will be omitted.

Referring to FIG. 9B (d), the manufacturing method may include the step of forming the channel layer 300 in a state where the insulating layer 400 is formed.

As described above, for example, the inner surfaces of the third insulator 230, the drain 130, the second insulator 220, the insulating layer 400, and the source 110 may form the same plane.

Accordingly, the channel layer 300 can be formed flatly without any protruding and/or recessed portions in the inner space formed by the hole V.

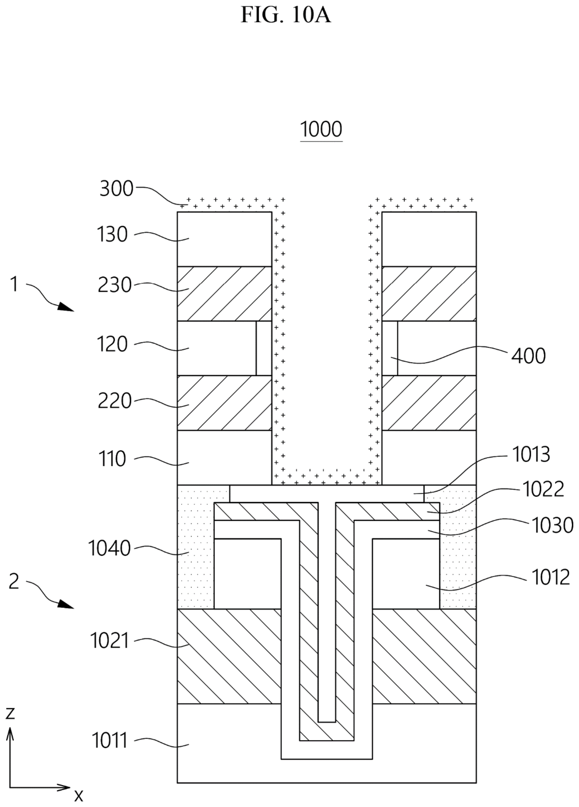

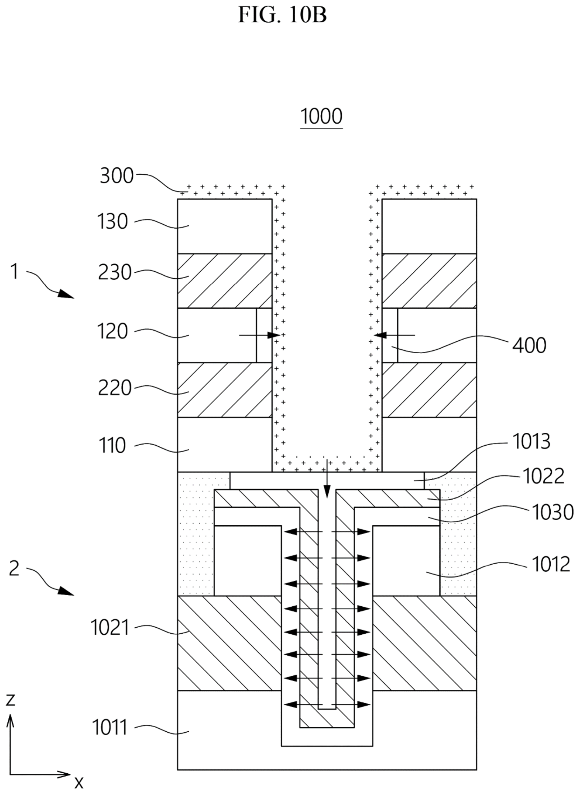

FIG. 10A is a view illustrating an example of a structure 1000 in which a GAA semiconductor device 1 and a CAA semiconductor device 2 are combined according to various embodiments. Hereinafter, the structure in FIG. 10A will be further described with reference to FIG. 10B.

FIG. 10B is a view illustrating an example of the operation of the structure 1000 according to various embodiments.

According to various embodiments, referring to FIG. 10A, the structure 1000 may further include the semiconductor device 2 below the components of the aforementioned semiconductor device 1 (e.g., source 110, gate 120, drain 130, insulators 210, 220, 230, insulating layer 400).

According to various embodiments, the CAA semiconductor device 2 may include a source 1011, an insulator 1021 disposed on the source 1011, a drain 1012 disposed on the insulator 1021, a channel layer 1030 formed vertically in a hole penetrating the drain 1012 and part of the insulator 1021 and the source 1011, an insulating layer 1022, a gate 1013, and a dielectric layer 1040.

Based on the channel layer 1030 and the gate 1013 being disposed vertically and the gate 1013 being implemented in a form that surrounds the channel layer 1030, the semiconductor device can be defined as a Channel All Around (CAA) semiconductor device 2.

Meanwhile, the source 1011 and the drain 1012 may be opposite to each other.

According to various embodiments, the source 1011, the drain 1012, and the gate 1013 may be a conductor.

The flow of current between the source 1011 and the drain 1012 can be controlled by the channel layer 1030, which functions as a channel controlled by the gate 1013 extending in the vertical direction.

According to various embodiments, the insulating layer 1022, which is disposed between the gate 1013 and the channel layer 1030 and formed in contact with each, is configured to electrically insulate the gate 1013 and the channel layer 1030.

The insulating layer 1022 can supply oxygen atoms (O2-) to the channel layer 1030 while having an electrical insulation function.

For example, the insulating layer 1022 may be implemented as Al2O3.

According to various embodiments, the channel layer 1030 can electrically connect the source 1011 and the drain 1012.

In a state where a channel is formed in the channel layer 1030 by the voltage (VG) applied to the gate 1013, current can flow in the channel layer 1030 by the voltage applied to the drain 1012 (or the source 1011).

Accordingly, referring to FIG. 10B, when a voltage is first applied to the gate 130 of the GAA semiconductor device 1 and a current (or voltage) is provided toward the source 110, a voltage is applied to the gate 1013 of the CAA semiconductor device 1, and when a channel is formed in the channel layer 1030 by the gate 1013 and a current is applied to the drain 1012, current can flow in the channel layer 1030.

According to various embodiments, the channel layer 1030 may be composed of IGZO (InGaZnO), Sn-IGZO, IWO (InWO), IZO (InZnO), ZTO (ZnSnO), ZnO, YZO (yttrium-doped zinc oxide), IGSO (InGaSiO), InO, SnO, TiO, ZnON, MgZnO, ZrInZnO, HfInZnO, SnInZnO, SiInZnO, GaZnSnO, ZrZnSnO, CNT, Graphene, Si, TMD, 2D material, organic semiconductor material, or a combination thereof.

Preferably, the channel layer 1030 may be implemented as IGZO (InGaZnO), which has a low leakage current and excellent electron mobility.

However, oxygen vacancies can occur inside the IGZO (InGaZnO) that constitutes the channel layer 1030, and free electrons (2e-) are formed for charge compensation due to the oxygen vacancies, which can reduce the resistance of the channel layer 1030.

However, as a movement path is formed by free electrons, the stability of the device is deteriorated, and control of the channel characteristics based on the voltage (VG) applied to the gate 1013 may become difficult.

According to various embodiments, the insulator 1021 may be an oxide film insulator containing oxygen atoms, which is in contact with a part of the channel layer 1030.

For example, the insulator 1021 may be implemented as SiO2.

Oxygen atoms contained in the insulator 1021 can be provided to the rest of the channel layer 1030.

Accordingly, the occurrence of oxygen vacancies in the rest of the channel layer 1030 is suppressed, and channel control by the voltage (VG) applied to the gate 1013 can be made smooth.

According to various embodiments, the method for manufacturing the structure 1000 can be implemented according to the step of manufacturing the aforementioned GAA semiconductor device 1 after manufacturing the CAA semiconductor device 2.

The method for manufacturing the CAA semiconductor device 2 includes the step of first forming a source 1011, an insulator 1021 on the source 1011, and a drain 1013 on the insulator 1021, followed by the step of forming a hole, and then the step of forming a channel layer 1030 through the hole, an insulating layer 1022 on the channel layer 1030, and a gate 1013 on the insulating layer 1022, and the step of forming an insulator 1040, and the step of manufacturing the aforementioned GAA semiconductor device 1 on the upper surface of the gate 1013 exposed through a part of the insulator 1040 can be performed.

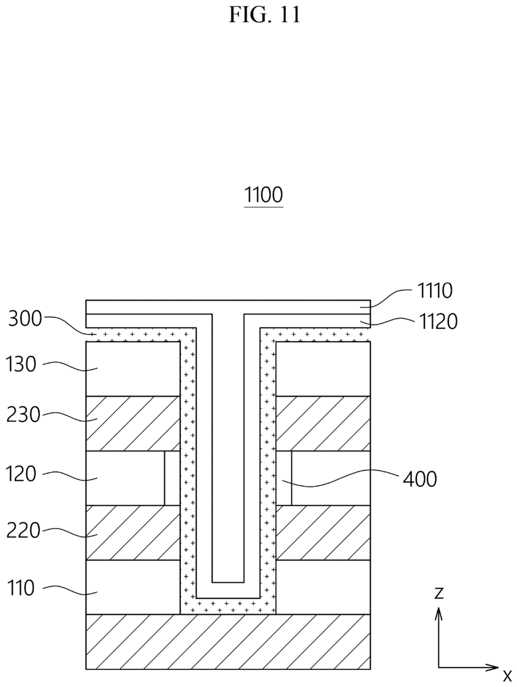

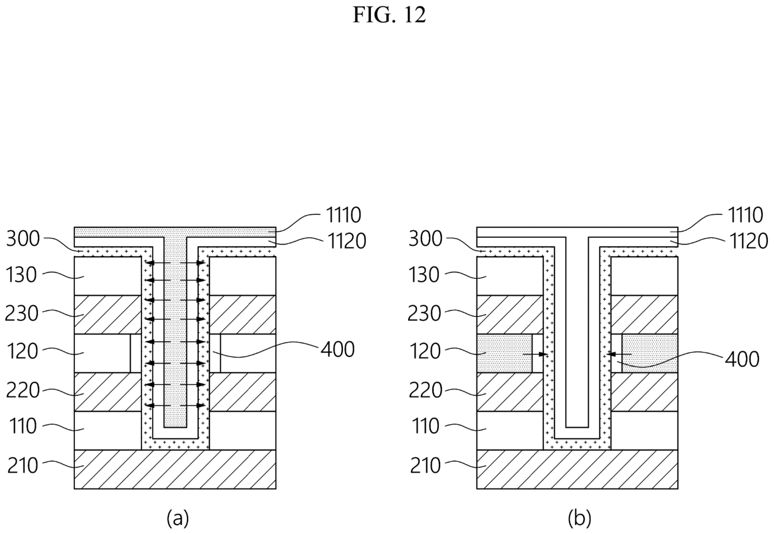

FIG. 11 is a view illustrating another example of a structure 1100 in which a GAA semiconductor device 1 and a CAA semiconductor device are combined according to various embodiments. Hereinafter, the structure in FIG. 11 will be further described with reference to FIG. 12.

FIG. 12 is a view illustrating an example of the operation of the structure 1100 according to various embodiments.

According to various embodiments, referring to FIG. 11, the structure 1100 may further include an additional structure comprising an additional insulating layer 1120 and an additional gate 1110 in addition to the components of the aforementioned GAA semiconductor device 1 (e.g., source 110, gate 120, drain 130, insulators 210, 220, 230, insulating layer 400).

For example, the additional gate 1110 is disposed in the hole V in the vertical direction, and an additional insulating layer 1120 surrounding (or covering) the additional gate 1110 is formed in contact with the additional gate 1110, and the additional insulating layer 1120 may be in contact with the channel layer 300.

According to various embodiments, the additional structure can be formed to penetrate the hole V of the GAA semiconductor device 1.

As the additional structure is formed in the vertical direction (e.g., the z-axis direction), as shown in FIG. 11 (a), the characteristics (e.g., conductivity) of the channel 300 connecting the source 110 and the drain 130 can be controlled by the voltage applied to the additional gate 1110, which can be defined as the aforementioned vertical structure CAA transistor 2.

As the conductivity of the channel 300 is controlled by the voltage applied to the additional gate 1110, a threshold voltage for the voltage applied to the additional gate 1110 can be set.

In a state where the threshold voltage is set, as shown in FIG. 11 (b), the activated state of the channel 300 can be determined by the voltage applied to the gate 120, as described above.

That is, when the channel 300 is activated, current flows between the source 110 and the drain 130, and when the channel 300 is deactivated, the flow of current can be limited.

According to various embodiments, the additional gate 1110 can be implemented with the same material as the aforementioned source 110, gate 120, and drain 130.

According to various embodiments, the additional insulating layer 1120, which is disposed between the additional gate 1110 and the channel layer 300 and formed in contact with each, is configured to electrically insulate the additional gate 1110 and the channel layer 300.

The additional insulating layer 1120 can be implemented as HfO2, SiO2, Al2O3, ZrO2, HZO, Ta2O5, La2O3, and Y2O3.

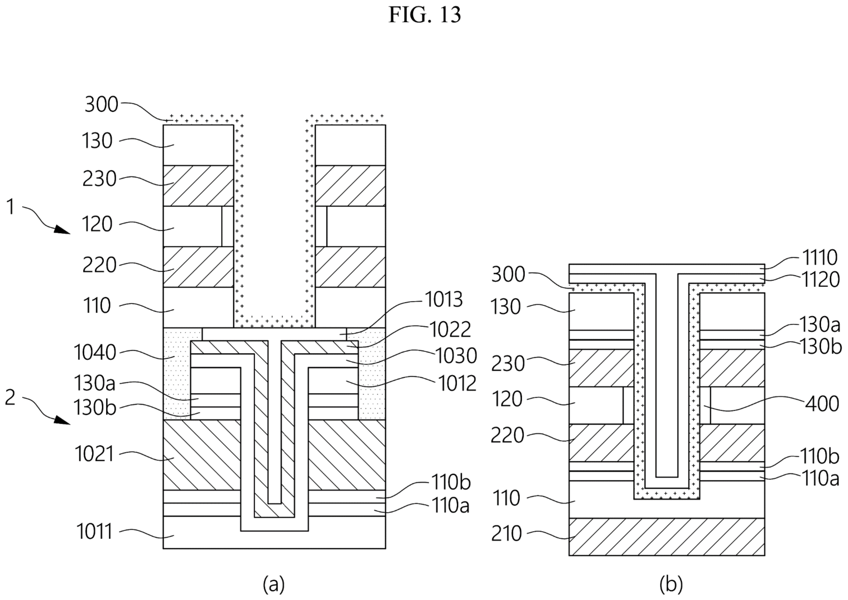

FIG. 13 is a view illustrating an example of a structure 1100 in which an oxygen tunnel is formed according to various embodiments.

According to various embodiments, FIG. 13 (a) illustrates an additional embodiment of the structure 1000 where the aforementioned GAA semiconductor 1 and CAA semiconductor 2 are connected, and FIG. 13 (b) illustrates an additional embodiment of the structure 1100 where a CAA semiconductor is implemented in the GAA semiconductor 1.

According to various embodiments, preferably, the channel layer (1030, 300) of the CAA semiconductor 2 in the structures (1000, 1100) may be implemented as IGZO (InGaZnO), which has a low leakage current and excellent electron mobility.

However, oxygen vacancies can occur inside the IGZO (InGaZnO) that constitutes the channel layer (1030, 300), and free electrons (2e-) are formed for charge compensation due to the oxygen vacancies, which can reduce the resistance of the channel layer 300.

However, as a movement path is formed by free electrons, the stability of the device is deteriorated, and control of the channel characteristics based on the voltage (VG) applied to the gate (1013, 1110) may become difficult.

Therefore, the structures (1000, 1100) may be configured to further include an oxygen tunnel structure that concentrates the flow of oxygen atoms to the channel (1030, 300) to prevent the induction of oxygen vacancies, in order to improve the stability of the aforementioned CAA semiconductor device.

For example, referring to FIG. 13, the source (1011, 110) and the drain (1012, 130) may each further include a contact layer (e.g., a first contact layer 110a and a second contact layer 130a) to reduce the contact resistance with the channel layer (1030, 300).

The contact layer (110a, 130a) can be implemented with the same material as the channel (1030, 300), and is preferably implemented as IGZO (InGaZnO), but is not limited to the described example.

For example, referring to FIG. 12, the structures (1000, 1100) may each further include an insulating layer (e.g., a first insulating layer 110b and a second insulating layer 130b) between the contact layer (110a, 130a) of the source (1011, 110) and the drain (1012, 130) and the insulator (1021, 220, 230).

The oxygen atom permeability of the insulating layer (e.g., the first insulating layer 110b, the second insulating layer 130b) may be lower than the oxygen atom permeability of the insulating layer (1022, 1120) in contact with the gate (1013, 1110) and the channel layer (1030, 300).

That is, the insulating layer (e.g., the first insulating layer 110b, the second insulating layer 130b) can form an oxygen tunnel structure that causes the oxygen atoms contained in the insulator (1021, 220, 230) to be concentrated to a part of the channel layer (1030, 300) in contact with the insulator (1021, 220, 230) (e.g., the region in contact with the insulator 1021, 220, 230).

In addition, the flow of oxygen atoms is prevented in the rest of the channel layer (1030, 300) connected to the contact layer (110a, 130a) and the source (1011, 110) and the drain (1012, 130), thereby inducing the generation of oxygen vacancies, consequently making the resistance of the rest of the channel layer (1030, 300) and the contact layer (110a, 110b) relatively lower than the resistance of the part of the channel layer (1030, 300) (e.g., the region in contact with the insulator 1021, 220, 230).

Accordingly, the contact resistance between the source (1011, 110) (or the drain 1012, 130) and the channel layer (1030, 300) can be lowered.

## Claims

1. A method for manufacturing a semiconductor device having a vertical channel structure, the method comprising:
forming a first insulator on a substrate, a first conductor on the first insulator, a second insulator disposed on the first conductor, a gate on the second insulator, a third insulator on the gate, and a second conductor on the third insulator;
forming a hole penetrating the second conductor, the third insulator, the gate, the second insulator, and the first conductor;
forming an insulating layer on an inner surface of the gate based on growing a blocking material on a remaining inner surface excluding the inner surface of the gate formed by the hole; and
forming a channel layer electrically connecting the first conductor and the second conductor.

2. The method of claim 1, wherein a functional group of the blocking material is configured to prevent the deposition of a material of the insulating layer.

3. The method of claim 2, wherein the forming an insulating layer on the inner surface of the gate comprises:
growing the blocking material on the inner surface formed by the hole;
selectively etching only the gate for a pre-set time; and
depositing the insulating layer in a trench structure formed in the gate in a state where the blocking material is grown on a remaining portion excluding the gate.

4. The method of claim 3, wherein the insulating layer of the gate electrically separates the gate and the channel layer.

5. The method of claim 2, wherein the forming an insulating layer on the inner surface of the gate comprises:
forming a layer that enables the growth of the blocking material on the inner surface formed by the hole;
selectively etching only the gate for a pre-set time;
growing the blocking material only on the remaining portion in a state where the remaining portion excluding the gate is hydrophilized; and
depositing the insulating layer in a trench structure formed in the gate in a state where the blocking material is grown on the remaining portion excluding the gate.

6. A semiconductor device having a vertical channel structure, comprising:
a first conductor;
a first insulator disposed on the first conductor;
a gate disposed on the first insulator;
a second insulator disposed on the gate;
a second conductor disposed on the second insulator;
a channel layer formed along an inner surface formed by a hole vertically penetrating the second conductor, the second insulator, the gate, and the first insulator; and
an insulating layer disposed between the channel layer and the gate,
wherein one of the first conductor and the second conductor is a source and the other is a drain, and
wherein the insulating layer is formed based on forming a blocking material that prevents the growth of the insulating layer inside the hole.

7. The semiconductor device of claim 6, wherein the insulating layer is formed between the inner surface of the gate and the channel layer.

8. The semiconductor device of claim 7,wherein the insulating layer is formed on the inner surface of the gate by depositing the material of the insulating layer in a state where a layer that prevents insulating film growth is grown on a remaining portion excluding the gate.

9. The semiconductor device of claim 8, wherein a functional group of the blocking material is configured to prevent the deposition of a material of the insulating layer.

10. The semiconductor device of claim 6, wherein an additional insulating layer and an additional gate are formed in the hole, and
the conductivity of the channel layer is adjustable by the additional gate.
